# FASCICULE DE BREVET EUROPEEN

(11) **EP 3 288 185 B1**
(45) Date de publication et mention de la délivrance du brevet: **01.01.2020**
(21) Numéro de dépôt: 17187857.2
(22) Date de dépôt: 25.08.2017
(51) Int. Cl.: H03K 17/0412, H01L 23/485, H03K 17/16

(54) **APPAREIL DE COMMUTATION ÉLECTRIQUE COMPORTANT UN DISPOSITIF D'INTERCONNEXION ÉLECTRIQUE AMÉLIORÉ**
ELEKTRISCHES SCHALTGERÄT, DAS MIT EINER VERBESSERTEN ELEKTRISCHEN VERBINDUNGSVORRICHTUNG AUSGESTATTET IST
ELECTRICAL SWITCHING APPARATUS COMPRISING AN IMPROVED ELECTRICALLY INTERCONNECT DEVICE

(30) Priorité: 26.08.2016 FR 1657958
(43) Date de publication de la demande: 28.02.2018
(73) Titulaire: ALSTOM Transport Technologies, 93400 Saint-Ouen (FR)
(72) Inventeur: AL KAYAL, Fisal, 1780 Wemmel (BE); DETONGRE, Christian, 6200 Chatelineau (BE)
(74) Mandataire: Lavoix

(56) Documents cités:
- FR-A1- 2 990 312
- US-A1- 2009 015 992
- US-A1- 2013 200 929

## Description

L'invention concerne un appareil de commutation électrique comportant un dispositif d'interconnexion électrique amélioré.

Il existe des appareils de commutation électrique dans le domaine de l'électronique de puissance, qui comportent des transistors de puissance et un dispositif de commande d'allumage de ces transistors adapté pour délivrer un signal de commande au travers d'une ou plusieurs interfaces de sortie. On connaît notamment de tels appareils comportant des transistors de puissance de technologie métal oxyde semi-conducteur à effet de champ, connus sous l'acronyme MOSFET, et réalisés en carbure de silicium. Il est possible que ces transistors de puissance soient groupés par deux au sein d'un composant de puissance, ou pack de puissance unitaire.

Dans des applications telles que les convertisseurs de puissance, les différents transistors de puissance répartis dans les composants de puissance doivent être commandés de façon synchronisée les uns par rapport aux autres. Il est souhaitable que le dispositif de commande d'allumage comporte une interface de sortie, ou « output voltage buffer » en langue anglaise, dédiée pour chacun des transistors de puissance. L'utilisation d'une interface de sortie dédiée pour chacun de ces transistors permet d'obtenir des performances de commande satisfaisantes.

Cependant, cette solution a pour désavantage d'être extrêmement coûteuse. De plus, elle induit un encombrement important. L'intégration physique d'un dispositif de commande d'allumage comportant plusieurs interfaces de sortie est donc extrêmement difficile, voire impossible pour les applications qui nécessitent un convertisseur de puissance miniaturisé présentant un encombrement réduit.

Pour pallier à cet inconvénient, il est connu d'utiliser une seule interface de sortie qui est commune à plusieurs composants de puissance commandés en parallèle. Les transistors de puissance respectifs sont ainsi raccordés en parallèle entre eux au dispositif de commande d'allumage, par l'intermédiaire de plusieurs câbles ou pistes électriquement conductrices. Une telle solution est par exemple décrite dans la demande de brevet FR 2 990 312 A1 ou la demande US 2013/0200929 A1.

Ce dispositif connu ne donne cependant pas entière satisfaction. Pour que les différents transistors soient commandés de façon synchronisée les uns par rapport aux autres, il est impératif que les câbles ou pistes électriquement conductrices présentent une même longueur. Les transistors de puissance doivent donc être placés à équidistance par rapport à l'interface de sortie. Cela complique l'agencement des différents constituants de l'appareil de commutation électrique. Cela impose en outre d'éloigner l'interface de sortie suffisamment loin des différents composants de puissance pour laisser suffisamment de place pour disposer les câbles ou pistes électriquement conductrices, ce qui a pour conséquence d'augmenter l'inductance électrique parasite due au câblage. La présence d'une telle inductance parasite peut engendrer une oscillation incontrôlée du signal de commande fourni par le dispositif de commande d'allumage et engendrer des dysfonctionnements de l'appareil de commutation électrique, voire même l'endommager irréversiblement.

C'est à ces inconvénients qu'entend plus particulièrement remédier l'invention en proposant un appareil de commutation électrique qui présente un encombrement maîtrisé et un coût raisonnable de fabrication, tout en permettant une commande d'allumage des transistors de puissance qui soit fiable et satisfaisante.

A cet effet, l'invention concerne un appareil de commutation électrique, comportant :
- au moins deux composants de puissance, incluant chacun des premier et deuxième transistors de puissance,
- un dispositif de commande d'allumage des transistors, configuré pour délivrer un premier signal de commande à chacun des premiers transistors et un deuxième signal de commande à chacun des deuxièmes transistors,
- un dispositif d'interconnexion électrique raccordant le dispositif de commande d'allumage aux composants de puissance pour transmettre les premier et deuxième signaux de commande aux premier et deuxième transistors,
dans lequel le dispositif d'interconnexion comporte plusieurs plaques électriquement conductrices s'étendant parallèlement entre elles, chacune de ces plaques électriquement conductrices étant raccordée entre une électrode de commande d'un des premier ou deuxième transistors de puissance et une sortie correspondante du dispositif de commande d'allumage,
dans lequel chaque premier transistor de puissance comporte des première et deuxième électrodes de commande, chaque deuxième transistor de puissance comporte des troisième et quatrième électrodes de commande et le dispositif d'interconnexion électrique comporte des première, deuxième, troisième et quatrième plaques électriquement conductrices raccordent électriquement, respectivement, les première, deuxième, troisième et quatrième électrodes de commande aux sorties respectives du dispositif de commande d'allumage,
dans lequel les première et deuxième plaques électriquement conductrices présentent une forme identique et sont superposées l'une avec l'autre,
dans lequel les troisième et quatrième plaques électriquement conductrices présentent une forme identique et sont superposées l'une avec l'autre,
et dans lequel les plaques électriquement conductrices sont empilées les unes avec les autres, les première et deuxième plaques électriquement conductrices étant décalées latéralement par rapport aux troisième et quatrième plaques électriquement conductrices de sorte à être superposées avec ces troisième et quatrième plaques électriquement conductrices uniquement au niveau d'une zone de recouvrement.

Grâce à l'invention, les plaques électriquement conductrices du dispositif d'interconnexion minimisent l'inductance parasite de câblage, tout en raccordant électriquement les composants de puissance à une même interface de sortie du dispositif de commande d'allumage de façon compacte.

Selon des aspects avantageux mais non obligatoires de l'invention, un tel appareil de commutation électrique peut incorporer une ou plusieurs des caractéristiques suivantes, prises dans toute combinaison techniquement admissible :
- Les première et deuxième plaques électriquement conductrices sont ménagées de part et d'autre d'un premier support électriquement isolant et les troisième et quatrième plaques conductrices sont ménagées de part et d'autre d'un deuxième support électriquement isolant.
- La zone de recouvrement présente une superficie inférieure ou égale à moins de 5%, de préférence inférieure ou égale à 2% de la superficie de l'une des plaques électriquement conductrices.
- Chacune des plaques électriquement conductrices présente une superficie supérieure ou égale à 1 cm² et inférieure ou égale à 10 cm².
- Les plaques électriquement conductrices sont réalisées en métal, par exemple en cuivre.
- Les premier et deuxième transistors de puissance sont des transistors métal-oxyde semi-conducteur à effet de champ ou des transistors bipolaires à grille isolée ou des transistors bipolaires.

L'invention sera mieux comprise et d'autres avantages de celle-ci apparaîtront plus clairement à la lumière de la description qui va suivre, d'un mode de réalisation d'un appareil de commutation électrique donnée uniquement à titre d'exemple et faite en référence aux dessins annexés, dans lesquels :
- la figure 1 est une illustration schématique d'un appareil de commutation électrique selon un premier mode de réalisation de l'invention ;
- la figure 2 est une illustration schématique, selon une vue éclatée, d'un dispositif d'interconnexion électrique de l'appareil de commutation électrique de la figure 1 ;
- la figure 3 est une illustration schématique d'un appareil de commutation électrique selon un deuxième mode de réalisation de l'invention ;
- la figure 4 est une illustration schématique, selon une vue éclatée, d'un dispositif d'interconnexion électrique de l'appareil de commutation électrique de la figure 3.

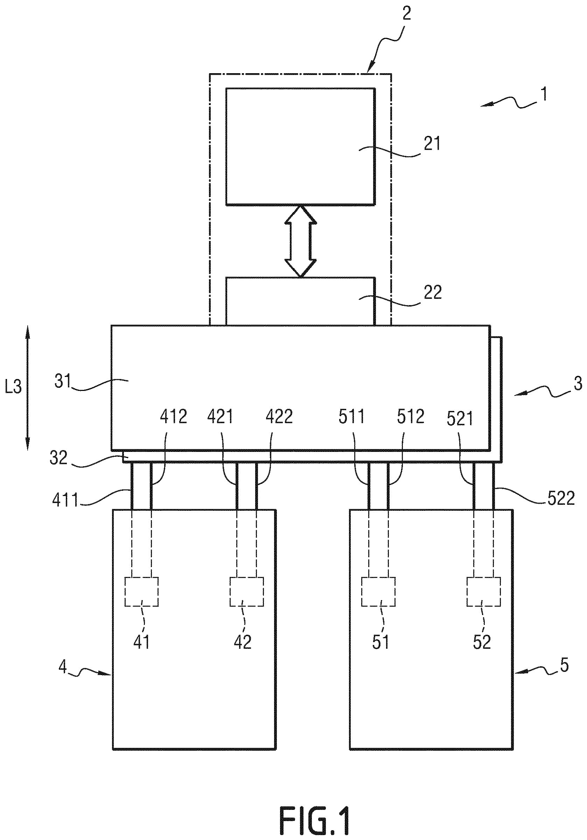

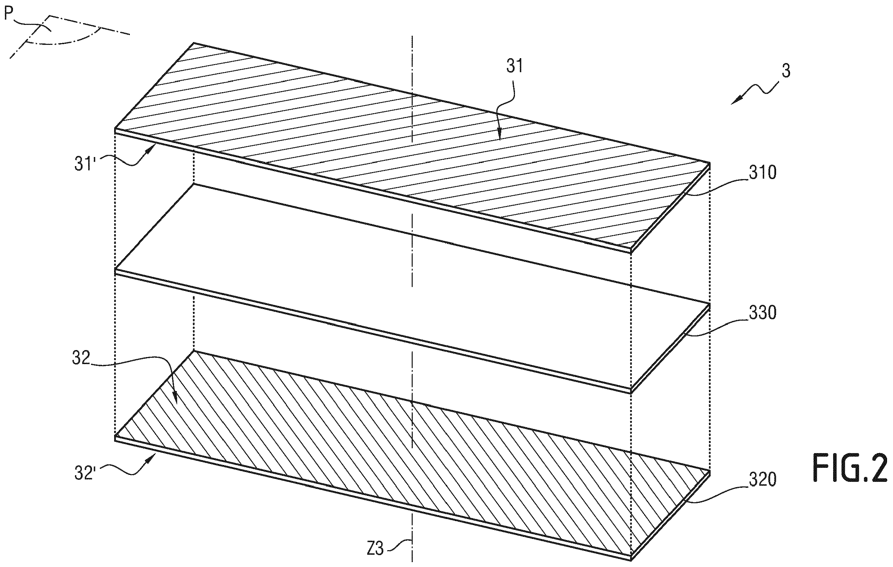

Les figures 1 et 2 représentent un premier mode de réalisation d'un appareil de commutation électrique 1.

L'appareil 1 comporte un dispositif de commande d'allumage 2, un dispositif d'interconnexion 3 et au moins deux composants de puissance 4 et 5.

Chacun des composants de puissance 4 et 5 inclut des premier et deuxième transistors de puissance. Dans cet exemple, les transistors de puissance sont des transistors de technologie métal oxyde semi-conducteur à effet de champ, connus sous l'acronyme MOSFET pour « Métal Oxide Semiconductor Field Effect Transistor » en langue anglaise. Ces transistors de puissance sont ici en carbure de silicium.

En variante, les premier et deuxième transistors de puissance sont des transistors bipolaires à grille isolée, ou des transistors bipolaires, ou tout autre transistor de technologie à semi-conducteur.

On note respectivement 41 et 42 les premier et deuxième transistors de puissance du premier composant de puissance 4. On note respectivement 51 et 52 les premier et deuxième transistors du composant de puissance 5. Dans cet exemple, les premiers transistors 41, 51 et les deuxièmes transistors 42, 52 de chacun des composants 4 et 5 sont identiques entre eux.

Le dispositif d'allumage 2 est configuré pour délivrer un premier signal de commande à chacun des premiers transistors 41 et 51 et pour délivrer un deuxième signal de commande à chacun des deuxièmes transistors 42 et 52, de manière à commander ces transistors en parallèle et de façon synchronisée.

Le dispositif d'allumage 2 comporte ici un circuit de commande d'allumage 21 et une interface de sortie 22 d'un signal de commande d'allumage. L'interface de sortie 22 est connectée au circuit de commande d'allumage 21. Les premier et deuxième signaux de commande sont générés par le circuit de commande 21 et sont transmis aux transistors 41, 42 et 51, 52 par l'intermédiaire de l'interface de sortie 22.

Chacun des transistors 41, 42, 51 et 52 est pourvu d'électrodes de commande qui permettent de piloter le fonctionnement du transistor correspondant, notamment pour commander le transistor correspondant entre des états électriquement passant ou bloquant, lorsque cette électrode de commande reçoit un signal de commande depuis le dispositif de commande 2.

On note respectivement 411 et 412 les premières électrodes du transistor 41, 421 et 422 les première et deuxième électrodes du transistor 42, 511 et 512 les première et deuxième électrodes du transistor 51 et 521 et 522 les première et deuxième électrodes du transistor 52.

Par exemple, dans le cas d'un transistor MOSFET, les premières électrodes 411, 421, 511 et 521 de chacun des transistors 41, 42, 51 et 52 correspondent à des électrodes de source de ces transistors. Les deuxièmes électrodes 412, 422, 512 et 522 de chacun des transistors 41, 42, 51 et 52 correspondent à des électrodes de grille de ces transistors.

Ainsi, les premier et deuxième signaux de commande sont respectivement des tensions de grille des premier et deuxième transistors 41, 42, 51 et 52. Plus précisément, le premier signal de commande est une différence de potentiel électrique destinée à être appliquée entre les électrodes de grille et de source de chaque premier transistor 41, 51. Le deuxième signal de commande est une différence de potentiel électrique destinée à être appliquée entre les électrodes de grille et de source de chaque deuxième transistor 42, 52.

Le dispositif d'interconnexion 3 raccorde électriquement l'interface de sortie 22 aux composants de puissance 4 et 5, de sorte à transmettre les premier et deuxième signaux de commande respectivement aux premier et deuxième transistors 41, 42, 51 et 52.

Ce dispositif d'interconnexion 3 comporte une ou plusieurs plaques électriquement conductrices, notées 31, 31', 32 et 32', qui s'étendent parallèlement entre elles et qui sont chacune raccordées entre une électrode de commande d'un des premier ou deuxième transistors d'une part, et une sortie correspondante de l'interface de sortie 22 du dispositif de commande d'allumage 2 d'autre part.

La figure 2 représente plus en détail un exemple des plaques 31, 31', 32 et 32'.

Les plaques 31 et 31' assurent la transmission du premier signal de commande depuis l'interface de sortie 22 vers les transistors 41 et 51. De façon analogue, les plaques 32 et 32' assurent la transmission du deuxième signal de commande vers transistors 42 et 52.

Les plaques 31, 31' 32 et 32' sont chacune de forme plane et s'étendent parallèlement à un plan géométrique P perpendiculairement à un axe transversal Z3. Les plaques 31 et 31' sont ménagées de part et d'autre d'un premier support électriquement isolant 310 du dispositif 3. De même, les plaques électriquement conductrices 32 et 32' sont ménagées de part et d'autre d'un deuxième support électriquement isolant 320 du dispositif 3. Les plaques 31, 31', 32 et 32' ont ici toute la même forme et sont superposées les unes avec les autres. Elles présentent toute une forme de quadrilatère régulier, tel qu'un parallélépipède rectangle. Les plaques 31, 31', 32 et 32' présentent ici chacune une superficie supérieure ou égale à 1 cm² et inférieure ou égale à 10 cm².

Les plaques 31, 31', 32 et 32' sont ici réalisées en un métal, tel que du cuivre, déposé sur des faces opposées des supports 310 et 320. Par exemple, les supports 310 et 320 sont des plaques de résine époxyde, de type PCB pour « Printed Circuit Board » en langue anglaise.

Ici, dans une configuration montée du dispositif 3, les supports 310 et 320 sont superposés de sorte à ce que la face du support 310 portant la plaque 31' soit tournée vers la face du support 320 qui porte la plaque 32.

Avantageusement, le dispositif 3 comporte une couche 330 d'un matériau électriquement isolant, interposée entre les plaques 31' et 32. Dans une configuration montée du dispositif 3, les plaques 32 et 31' sont en contact avec la couche du matériau isolant 330.

Dans cet exemple, la première plaque 31 est connectée électriquement aux premières électrodes 411 et 511. La deuxième plaque 31' est connectée électriquement aux deuxièmes électrodes 412 et 512. La troisième plaque 32 est connectée électriquement aux troisièmes électrodes 421 et 521. La quatrième plaque 32' est connectée électriquement aux quatrièmes électrodes 422 et 522. Ces connexions électriques sont par exemple réalisées au moyen d'un élément de raccordement, non illustré, ou en soudant directement les électrodes correspondantes du transistor sur chacune des plaques 31, 31', 32 et 32'.

De plus, chacune des plaques 31, 31', 32 et 32' est connectée électriquement à une sortie correspondante de l'interface de sortie 22. Par exemple, l'interface de sortie 22 comporte quatre sorties comportant chacune un terminal porté à un potentiel électrique spécifique et destiné à être connecté électriquement à l'une des première, deuxième, troisième ou quatrième électrodes 411, 412, 421, 422, 511, 512, 521, 522. L'application des premier et deuxième signaux de commande revient ainsi à appliquer le potentiel électrique correspondant sur chacune des électrodes 411, 412, 421, 422, 511, 512, 521, 522.

Le dispositif 3 permet ainsi de connecter les composants de puissance 4 et 5 à l'interface de sortie 22 avec un encombrement réduit et sans avoir besoin d'installer un câblage spécifique, dont la longueur serait compliquée à optimiser pour minimiser l'inductance parasite de câblage.

Dans cet exemple, la longueur L3 du dispositif 3, c'est-à-dire la distance entre l'interface de sortie 22 et les électrodes 411, 412, 421, 422, 511, 512, 521 et 522, est inférieure ou égale à 5 cm, de préférence inférieure ou égale à 1 cm.

En variante, l'appareil 1 comporte plus de deux composants de puissance. Le dispositif 3 est alors adapté en conséquence. Par exemple, l'appareil 1 comporte un troisième composant de puissance, non illustré, identique au composant de puissance 4 ou 5 et comportant des premier et deuxième transistors identiques à ceux des composants de puissance 4 et 5. Dans ce cas, chacune des plaques 31, 31', 32, 32' est en outre raccordée à l'électrode correspondante d'un des transistors de ce composant de puissance de la même façon que pour les composants de puissance 4 et 5.

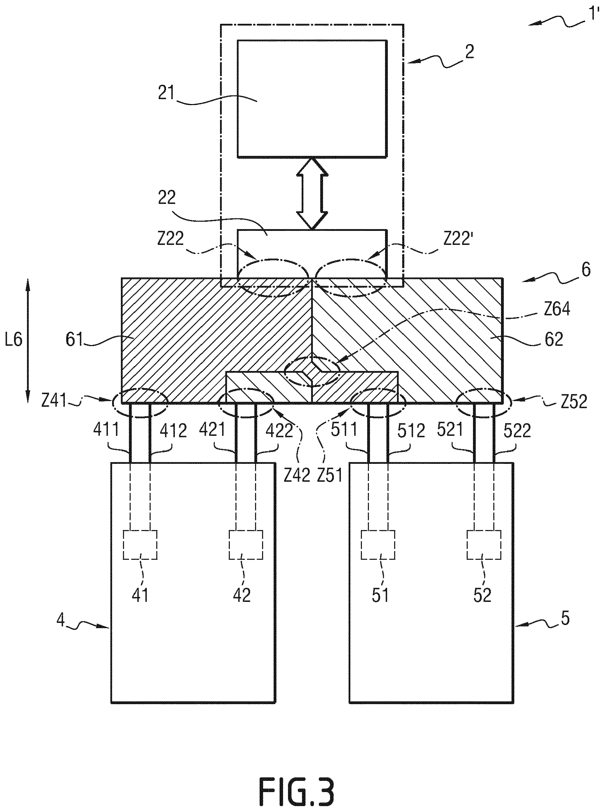

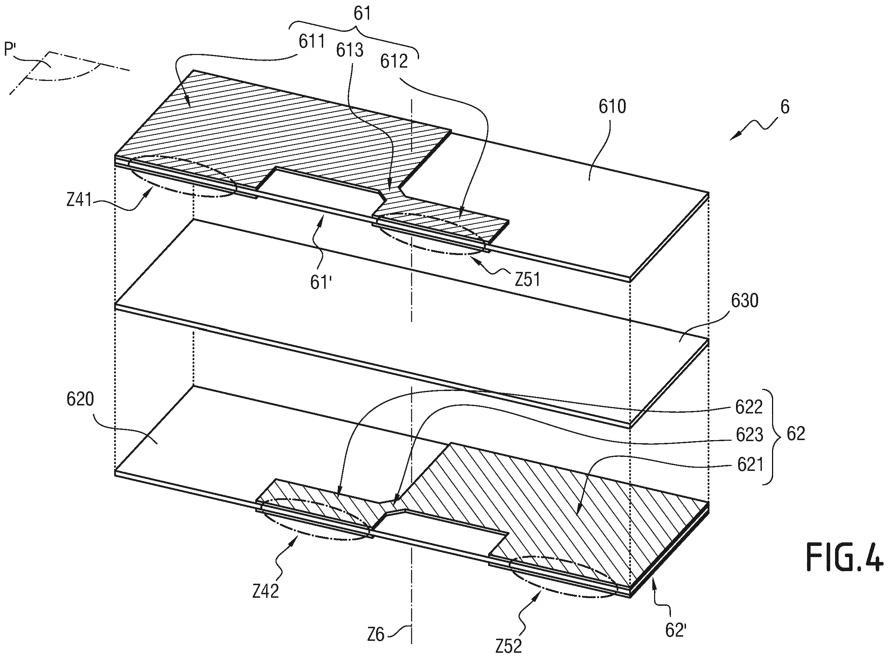

Les figures 3 et 4 représentent un deuxième mode de réalisation de l'invention. Les éléments de l'appareil de commutation selon ce mode de réalisation qui sont analogues à ceux du premier mode de réalisation portent les mêmes références et ne sont pas décrits en détail, dans la mesure où la description ci-dessus peut leur être transposée.

Plus précisément, les figures 3 et 4 représentent un appareil de commutation électrique 1'. Cet appareil 1' comporte un dispositif d'interconnexion 6 qui remplace et joue un rôle analogue à celui du dispositif d'interconnexion 3 de l'appareil 1 précédemment décrit.

Le dispositif 6 comporte quatre plaques électriquement conductrices, notées 61, 61', 62 et 62', s'étendant parallèlement entre elles et raccordant chacune l'un des premier et deuxième transistors d'une part et une sortie correspondante de l'interface de sortie 22 du dispositif de commande de l'allumage 2 d'autre part. Les plaques 61, 61', 62 et 62' s'étendent parallèlement à un plan géométrique P' et perpendiculairement à un axe transversal Z6 du dispositif 6.

Les plaques 61 et 61' assurent la transmission du premier signal de commande depuis l'interface de sortie 22 vers les transistors 41 et 51. De façon analogue, les plaques 62 et 62' assurent la transmission du deuxième signal de commande vers transistors 42 et 52. Dans cet exemple, la première plaque 61 est connectée électriquement aux premières électrodes 411 et 511. La deuxième plaque 61' est connectée électriquement aux deuxièmes électrodes 412 et 512. La troisième plaque 52 est connectée électriquement aux troisièmes électrodes 421 et 521. La quatrième plaque 62' est connectée électriquement aux quatrièmes électrodes 422 et 522. Ces connexions électriques sont par exemple réalisées au moyen d'un élément de raccordement, non illustré, ou en soudant directement les électrodes correspondantes du transistor sur chacune des plaques 61, 61', 62 et 62'.

Les plaques 61, 61' sont ici ménagées sur des faces opposées d'un support électriquement isolant 610 du dispositif 6. De façon analogue, les plaques 62 et 62' sont ménagés sur des faces opposées d'un support électriquement isolant 620 du dispositif 6. Les supports 610 et 620 sont par exemple analogues aux supports 310 et 320.

Chacune des plaques 61, 61', 62 et 62' est ici formé d'un matériau métallique, tel que du cuivre, déposé sur les faces correspondantes des supports 610 et 620.

Les plaques 61 et 61' présentent ici une forme identique. Plus précisément, la surface occupée par la plaque 61' correspond à une transposée selon la direction d'axe Z6 de la surface occupée par la plaque 61. De façon analogue, les plaques 62, 62' présentent une même forme et la surface occupée par la plaque 62' correspond à une transposée de la surface occupée par la plaque 62 selon la direction d'axe Z6.

Les première et deuxième plaques 61 et 61' sont décalées latéralement par rapport aux troisième et quatrième plaques 62 et 62', c'est-à-dire décalées selon une direction appartenant au plan géométrique P'. Avantageusement, le dispositif 6 comporte une couche d'un matériau électriquement isolant 630, qui joue le même rôle que la couche 330 précédemment décrite.

Chacune des plaques 61 et 61' présente un recouvrement avec les plaques 62 et 62' qui est le plus faible possible. A cet effet, les plaques 61 et 61' sont superposées avec les plaques 62 et 62' uniquement au niveau d'une zone de recouvrement Z64. Par exemple, la projection orthogonale, dans le plan géométrique P', des surfaces occupées par les couches 61 et 61' est essentiellement disjointe de la projection orthogonale, dans ce même plan géométrique P', des superficies occupées par les plaques 62 et 62'. Par essentiellement disjointe, on entend la superficie de la zone de recouvrement Z64 est inférieure ou égale à 5% de la superficie de la surface projetée dans le plan P' des plaques 61, 61', de préférence inférieure ou égale à 2% de cette superficie. A titre d'exemple illustratif, cette superficie de la zone de recouvrement Z64 est égale à 5 mm².

Dans cet exemple, la plaque 61 comporte une partie principale de forme polygonale, une partie secondaire en forme de quadrilatère et une partie de raccordement 613 qui relier la partie secondaire 612 à la partie principale 611. La partie principale 611 s'étend sur une partie la face supérieure du support 610, entre une zone Z22 d'interface avec une sortie correspondante de l'interface de sortie 22 d'une part, et une zone Z41 d'interface avec le premier transistor 41 d'autre part. La partie 612 est adjacente à la partie 611 et est placée en regard d'une zone Z51 d'interface avec le premier transistor 51. La portion 613 raccorde la partie 612 à la partie 611.

La plaque 62 présente une structure analogue et comporte des parties 621, 622 et 623. La partie 621 s'étend sur une face supérieure du support 620 entre d'une part une zone Z22' d'interface avec une sortie correspondante de l'interface de sortie 22 et d'autre part, une zone Z52 d'interface avec le deuxième transistor 52. La partie 622 est placée sur un bord du support 620 en regard d'une zone Z42 d'interface avec le deuxième transistor.

La zone d'interface d'un transistor désigne la portion du dispositif 6 qui est placée en regard des électrodes de ce transistor lorsque le dispositif 6 est dans une configuration montée. Par exemple, la zone d'interface Z41 correspond à la portion du dispositif 6 qui est placée en regard des électrodes 411 et 412. Il en va de même pour les zones Z22 et Z22' vis-à-vis de l'interface de sortie 22.

Dans une configuration montée du dispositif 6, les plaques 61' et 62 sont en contact avec la couche 630.

Grâce au dispositif 6, les performances de l'appareil de commutation sont améliorées, en particulier par rapport au dispositif d'interconnexion 3. En minimisant le recouvrement entre les plaques 61, 61' d'une part et les plaques 62, 62' d'autre part, on réduit les inductances parasites de câblage qui pourraient survenir entre ces plaques respectives et qui pourraient créer des interférences entre les premier et deuxième signaux de commande, ce qui dégraderait le fonctionnement de l'appareil de commutation électrique 1.

De plus, la disposition particulière des plaques 61, 61', 62 et 62' permet d'obtenir un dispositif 6 aussi compact que le dispositif 3. En particulier, la distance L6 du dispositif 6 entre l'interface de sortie 22 et les composants 4 et 5 est inférieure à 5 cm, de préférence inférieure à 1 cm. La distance L6 est ici définie de façon analogue à la distance L3 précédemment décrite.

De même que précédemment décrit en référence à l'appareil 1, l'appareil 1' peut comporter plus de deux composants de puissance dont les transistors de puissance sont raccordés à l'interface de sortie 22 par le dispositif 6.

Les modes de réalisation et variantes envisagés ci-dessus peuvent être combinés entre eux pour générer de nouveaux modes de réalisation de l'invention.

## Revendications

1. Appareil (1 ;1') de commutation électrique, comportant :
- au moins deux composants de puissance (4, 5), incluant chacun des premier (41, 51) et deuxième (42, 52) transistors de puissance,
- un dispositif de commande d'allumage (2) des transistors, configuré pour délivrer un premier signal de commande à chacun des premiers transistors (41, 51) et un deuxième signal de commande à chacun des deuxièmes transistors (42, 52),
- un dispositif d'interconnexion électrique (3 ; 6) raccordant le dispositif de commande d'allumage (2) aux composants de puissance (4, 5) pour transmettre les premier et deuxième signaux de commande aux premier et deuxième transistors,
le dispositif d'interconnexion (3 ; 6) comportant plusieurs plaques électriquement conductrices (31, 31', 32, 32' ; 61, 61', 62, 62') s'étendant parallèlement entre elles, chacune de ces plaques électriquement conductrices étant raccordée entre une électrode de commande d'un des premier ou deuxième transistors de puissance (41, 42, 51, 52) et une sortie correspondante du dispositif de commande d'allumage (2),
chaque premier transistor de puissance (41, 51) comportant des première (411, 511) et deuxième (412, 512) électrodes de commande, chaque deuxième transistor de puissance (42, 52) comportant des troisième (421, 521) et quatrième (422, 522) électrodes de commande et le dispositif d'interconnexion électrique comportant des première (31 ; 61), deuxième (31' ; 61'), troisième (32 ; 62) et quatrième (32' ; 62') plaques électriquement conductrices qui raccordent électriquement, respectivement, les première (411, 511), deuxième (412, 512), troisième (421, 521) et quatrième (422, 522) électrodes de commande aux sorties respectives du dispositif de commande d'allumage (2),
cet appareil de commutation électrique étant **caractérisé en ce que** les première (31 ; 61) et deuxième (31'; 61') plaques électriquement conductrices présentent une forme identique et sont superposées l'une avec l'autre,
**en ce que** les troisième (32 ; 62) et quatrième (32' ; 62') plaques électriquement conductrices présentent une forme identique et sont superposées l'une avec l'autre,
et **en ce que** les plaques électriquement conductrices sont empilées les unes avec les autres, les première (31 ; 61) et deuxième (31' ; 61') plaques électriquement conductrices étant décalées latéralement par rapport aux troisième (32 ; 62) et quatrième (32' ; 62') plaques électriquement conductrices de sorte à être superposées avec ces troisième et quatrième plaques électriquement conductrices uniquement au niveau d'une zone de recouvrement (Z64).

2. Appareil selon la revendication 1, **caractérisé en ce que** les première et deuxième plaques électriquement conductrices sont ménagées de part et d'autre d'un premier support (310 ; 610) électriquement isolant et **en ce que** les troisième et quatrième plaques électriquement conductrices sont ménagées de part et d'autre d'un deuxième support (320 ; 620) électriquement isolant.

3. Appareil selon la revendication 1 ou 2, **caractérisé en ce que** la zone de recouvrement (Z64) présente une superficie inférieure ou égale à moins de 5%, de préférence inférieure ou égale à 2% de la superficie de l'une des plaques électriquement conductrices.

4. Appareil selon l'une quelconque des revendications précédentes, **caractérisé en ce que** chacune des plaques électriquement conductrices (31, 31', 32, 32' ; 61, 61', 62, 62') présente une superficie supérieure ou égale à 1 cm² et inférieure ou égale à 10 cm².

5. Appareil selon l'une quelconque des revendications précédentes, **caractérisé en ce que** les plaques électriquement conductrices (31, 31', 32, 32' ; 61, 61', 62, 62') sont réalisées en métal, par exemple en cuivre.

6. Appareil selon l'une quelconque des revendications précédentes, **caractérisé en ce que** les premier et deuxième transistors de puissance (41, 42, 51, 52) sont des transistors métal-oxyde semi-conducteur à effet de champ ou des transistors bipolaires à grille isolée ou des transistors bipolaires.

## Patentansprüche

1. Elektrisches Schaltgerät (1; 1'), umfassend:
- mindestens zwei Leistungsbauelemente (4, 5), die jeweils einen ersten (41, 51) und einen zweiten (42, 52) Leistungstransistor aufweisen,
- eine Ansteuervorrichtung (2) zur Ansteuerung der Transistoren, die zur Ausgabe jeweils eines ersten Steuersignals an die ersten Transistoren (41, 51) und jeweils eines zweiten Steuersignals an die zweiten Transistoren (42, 52) ausgebildet ist,
- eine elektrische Verbindungsvorrichtung (3; 6), welche die Ansteuervorrichtung (2) zur Übertragung der ersten und der zweiten Steuersignale an die ersten und die zweiten Transistoren mit den Leistungsbauteilen (4, 5) verbindet,
wobei die Verbindungsvorrichtung (3; 6) mehrere elektrisch leitende Platten (31, 31'; 32, 32'; 61, 61'; 62, 62') umfasst, die sich parallel zueinander erstrecken, wobei die elektrisch leitenden Platten jeweils zwischen eine Steuerelektrode eines der ersten oder zweiten Leistungstransistoren (41, 42, 51, 52) und einen entsprechenden Ausgang der Ansteuervorrichtung (2) geschaltet sind, wobei die ersten Leistungstransistoren (41, 51) jeweils eine erste (411, 511) und eine zweite (412, 512) Steuerelektrode aufweisen, die zweiten Leistungstransistoren (42, 52) jeweils eine dritte (421, 521) und eine vierte (422, 522) Steuerelektrode aufweisen und die elektrische Verbindungsvorrichtung eine erste (31; 61), eine zweite (31'; 61'), eine dritte (32, 62) und eine vierte elektrisch leitende Platte (32'; 62') aufweist, welche die erste (411, 511) bzw. die zweite (412, 512) bzw. die dritte (421, 521) bzw. die vierte (422, 522) Steuerelektrode elektrisch mit den jeweiligen Ausgängen der Ansteuervorrichtung (2) verbinden,
**dadurch gekennzeichnet, dass**
die erste (31; 61) und die zweite (31'; 61') elektrisch leitende Platte die gleiche Form aufweisen und übereinander angeordnet sind, dass die dritte (32; 62) und die vierte (32'; 62') elektrisch leitende Platte die gleiche Form aufweisen und übereinander angeordnet sind und dass die elektrisch leitenden Platten übereinandergestapelt sind, wobei die erste (31; 61) und die zweite (31'; 61') elektrisch leitende Platte gegenüber der dritten (32; 62) und der vierten (32'; 62') elektrisch leitenden Platte seitlich versetzt sind, so dass sie nur in einem Überdeckungsbereich (Z64) über der dritten und der vierten elektrisch leitenden Platte angeordnet sind.

2. Elektrisches Schaltgerät nach Anspruch 1, **dadurch gekennzeichnet, dass** die erste und die zweite elektrisch leitende Platte auf beiden Seiten eines ersten elektrisch isolierenden Trägers (310; 610) angeordnet sind und dass die dritte und die vierte elektrisch leitende Platte auf beiden Seiten eines zweiten elektrisch isolierenden Trägers (320; 620) angeordnet sind.

3. Elektrisches Schaltgerät nach Anspruch 1 oder 2, **dadurch gekennzeichnet, dass** der Überdeckungsbereich (Z64) eine Fläche aufweist, die weniger als 5 %, vorzugsweise höchstens 2 %, der Fläche einer der elektrisch leitenden Platten beträgt.

4. Elektrisches Schaltgerät nach einem der vorhergehenden Ansprüche, **dadurch gekennzeichnet, dass** die elektrisch leitenden Platten (31, 31'; 32, 32'; 61, 61'; 62, 62') jeweils eine Fläche aufweisen, die mindestens 1 cm² und höchstens 10 cm² beträgt.

5. Elektrisches Schaltgerät nach einem der vorhergehenden Ansprüche, **dadurch gekennzeichnet, dass** die elektrisch leitenden Platten (31, 31'; 32, 32'; 61, 61'; 62, 62') aus Metall, vorzugsweise aus Kupfer, ausgebildet sind.

6. Elektrisches Schaltgerät nach einem der vorhergehenden Ansprüche, **dadurch gekennzeichnet, dass** die ersten und die zweiten Leistungstransistoren (41, 42, 51, 52) Metall-Oxid-Halbleiter-Feldeffekttransistoren oder Bipolartransistoren mit isolierter Gate-Elektrode oder Bipolartransistoren sind.

## Claims

1. An electrical switching apparatus (1; 1'), comprising:
- at least two power components (4, 5), each including first (41, 51) and second (42, 52) power transistors,
- an illumination control device (2) of the transistors, configured to deliver a first control signal to each of the first transistors (41, 51) and a second control signal to each of the second transistors (42, 52),
- an electrical interconnect device (3; 6) connecting the illumination control device (2) to the power components (4, 5) to transmit the first and second control signals to the first and second transistors,
the interconnect device (3; 6) comprising several electrically conductive plates (31, 31', 32, 32'; 61, 61', 62, 62') extending parallel to one another, each of these electrically conductive plates being connected between a control electrode of one of the first or second power transistors (41, 42, 51, 52) and a corresponding output of the illumination control device (2), each first power transistor (41, 51) comprising first (411, 511) and second (412, 512) control electrodes, each second power transistor (42, 52) comprising third and fourth control electrodes (421, 521), and the electrical interconnect device comprising first (31; 61), second (31'; 61'), third (32; 62) and fourth (32'; 62') electrically conductive plates electrically connecting the first (411, 511), second (412, 512), third (421, 521) and fourth (422, 522) control electrodes, respectively, to the respective outputs of the illumination control device (2),
this electrical switching apparatus being **characterized in that**
the first (31; 61) and second (31'; 61') electrically conductive plates have an identical shape and are superimposed with one another,
the third (32; 62) and fourth (32'; 62') electrically conductive plates have an identical shape and are superimposed with one another,
and the electrically conductive plates are stacked with one another, the first (31; 61) and second (31'; 61') electrically conductive plates being laterally offset relative to the third (32; 62) and fourth (32'; 62') electrically conductive plates so as to be superimposed with these third and fourth electrically conductive plates only at an overlap zone (Z64).

2. The apparatus according to claim 1, **characterized in that** the first and second electrically conductive plates are arranged on either side of a first electrically insulating support (310; 610) and **in that** the third and fourth conductive plates are arranged on either side of a second electrically insulating support (320; 620).

3. The apparatus according to any one of claims 1 or 2, **characterized in that** the overlap zone (Z64) has a surface area smaller than or equal to less than 5%, preferably less than or equal to 2% of the surface area of one of the electrically conductive plates.

4. The apparatus according to any one of the preceding claims, **characterized in that** each of the electrically conductive plates (31, 31', 32, 32'; 61, 61', 62, 62') has a surface area greater than or equal to 1 cm² and less than or equal to 10 cm².

5. The apparatus according to any one of the preceding claims, **characterized in that** the electrically conductive plates (31, 31', 32, 32'; 61, 61', 62, 62') are made from metal, for example copper.

6. The apparatus according to any one of the preceding claims, **characterized in that** the first and second power transistors (41, 42, 51, 52) are metal oxide semiconductor field effect transistors or isolated gate bipolar transistors or bipolar transistors.
